# EUROPEAN PATENT APPLICATION

(11) **EP 4 726 410 A1**
(43) Date of publication of application: **15.04.2026**
(21) Application number: 25742080.2
(22) Date of filing: 14.01.2025
(51) Int. Cl.: G01R 31/382, G01R 31/396, G01R 17/20, G01R 19/10, H02J 7/00, B60L 58/12

(54) **BATTERY DIAGNOSTIC DEVICE AND METHOD**

(30) Priority: 17.01.2024 KR 20240007618
(71) Applicant: LG Energy Solution, Ltd., Seoul 07335 (KR)
(72) Inventor: PARK, Jun-Cheol, Daejeon 34122 (KR); KIM, Young-Deok, Daejeon 34122 (KR); KIM, Ji-Yeon, Daejeon 34122 (KR)
(74) Representative: Goddar, Heinz J.
(86) International application number: PCT/KR2025/000811
(87) International publication number: WO 2025/155064

(57) **Abstract**

A battery diagnosing method according to one aspect of the present disclosure includes a sampling step of sampling an OCV value of a target battery within a partial SOC range among an entire SOC range of the target battery; a generation step of generating an estimated profile, which estimates OCV values of the target battery corresponding to the entire SOC range based on the OCV values sampled within the partial SOC range; and a diagnosis step of diagnosing the target battery based on the estimated profile.

## Description

### TECHNICAL FIELD

This application is based on and claims priority from Korean Patent Application No. 10-2024-0007618, filed on January 17, 2024, with the Korean Intellectual Property Office, the disclosure of which is incorporated herein in its entirety by reference.

The present disclosure relates to a battery diagnosing apparatus and method, and more particularly, a battery diagnosing apparatus and method for diagnosing a state of a battery capable of charging and discharging.

### BACKGROUND ART

Recently, as the demand for portable electronic products such as notebook computers, digital cameras, and portable telephones has rapidly increased, and as the development of electric vehicles, energy storage systems, robots, and satellites has begun in earnest, researches on the high-performance batteries allowing charging and discharging are actively underway.

Types of rechargeable batteries include lithium batteries that use lithium ions, such as lithium-ion batteries and lithium-ion polymer batteries, as well as nickel-cadmium batteries, nickel-metal hydride batteries, and nickel-zinc batteries. Of these batteries, lithium batteries have several advantages of exhibiting almost no memory effect, resulting in a relatively long lifespan, very low self-discharge rate, and high energy density, as compared to nickel-based batteries. Due to these advantages, the application range of lithium batteries is gradually expanding.

A positive electrode and negative electrode of a battery gradually deteriorate, respectively, as the number of charge and discharge cycles of the battery increases, leading to a reduction in electrical capacity.

In conventional technologies, to diagnose whether a battery has deteriorated, the battery status is diagnosed by continuously measuring the Closed Circuit Voltage (CCV) of the battery while charging and discharging the battery at a low current rate of about 0.05 C (C-rate). However, this approach requires a significant amount of time for battery diagnosis and makes it difficult to perform real-time diagnosis during the use of the battery.

Further, in conventional technologies, when the battery is charged and discharged at a high current rate of 0.3 C or higher in order to shorten the battery diagnosis time, the measured CCV of the battery includes an overpotential, which prevents accurate diagnosis of the current status of the battery due to the influence of this overpotential.

### DISCLOSURE

### Technical Problem

In one embodiment of the present disclosure, there are provided a battery diagnosing apparatus and method to shorten the battery diagnosis time and enable diagnosis for batteries that are charged and discharged at a high current rate.

### Technical Solution

A battery diagnosing method according to one aspect of the present disclosure includes: a sampling step of sampling an Open Circuit Voltage (OCV) value of a target battery within a partial SOC range among an entire State of Charge (SOC) range of the target battery; a generation step of generating an estimated profile, which estimates OCV values of the target battery corresponding to the entire SOC range based on the OCV values sampled within the partial SOC range; and a diagnosis step of diagnosing the target battery based on the estimated profile.

In one embodiment, the sampling step may include sampling the OCV value of the target battery at each idle period of the target battery that occurs discontinuously within the partial SOC range during charge or discharge of the target battery.

In one embodiment, the sampling step may include sampling the OCV value of the target battery a number of times corresponding to a predetermined reference number of times within the partial SOC range.

In one embodiment, the generation step may include: a first generation step of generating a second positive electrode profile and second negative electrode profile corresponding to the sampled OCV values based on a first positive electrode profile representing a correlation between an SOC and a positive electrode potential of a predetermined reference battery and a first negative electrode profile representing a correlation between the SOC and a negative electrode potential of the reference battery, prior to generating the estimated profile; and a second generation step of generating the estimated profile based on the second positive electrode profile and the second negative electrode profile.

In one embodiment, the first generation step may include generating the second positive electrode profile and the second negative electrode profile by changing at least one of a position, scale, and shape of the first positive electrode profile and the first negative electrode profile on a predetermined coordinate axis.

In one embodiment, the second generation step may include generating the estimated profile by calculating a potential difference for each SOC between the second positive electrode profile and the second negative electrode profile.

In one embodiment, the diagnosis step may include: obtaining an estimated positive electrode profile that estimates a correlation between an SOC and a positive electrode potential of the target battery and an estimated negative electrode profile that estimates a correlation between the SOC and a negative electrode potential of the target battery from the estimated profile; and diagnosing the target battery using information included in at least one of the estimated positive electrode profile and the estimated negative electrode profile.

In one embodiment, the information may include at least one of an initial potential, final potential, and shrinkage of the estimated positive electrode profile, and an initial potential, final potential, and shrinkage of the estimated negative electrode profile. The shrinkage of the estimated positive electrode profile may indicate a degree of shrinkage of the estimated positive electrode profile in a predetermined direction compared to a predetermined reference positive electrode profile, and the shrinkage of the estimated negative electrode profile may indicate a degree of shrinkage of the estimated negative electrode profile in a predetermined direction compared to a predetermined reference negative electrode profile.

In one embodiment, the battery diagnosing method may further include a step of adjusting a full-charge voltage of the target battery or a current rate of charge current or discharge current of the target battery based on a diagnosis result from the diagnosis step.

A battery diagnosing apparatus according to another aspect of the present disclosure includes an OCV sampling unit configured to sample an Open Circuit Voltage (OCV) value of a target battery within a partial SOC range among an entire State of Charge (SOC) range of the target battery; an estimated profile generation unit configured to generate an estimated profile, which estimates OCV values of the target battery corresponding to the entire SOC range based on the OCV values sampled within the partial SOC range; and a diagnosis unit configured to diagnose the target battery based on the estimated profile.

In one embodiment, the estimated profile generation unit may include a first generation module configured to generate a second positive electrode profile and second negative electrode profile corresponding to the sampled OCV values based on a first positive electrode profile representing a correlation between an SOC and a positive electrode potential of a predetermined reference battery and a first negative electrode profile representing a correlation between the SOC and a negative electrode potential of the reference battery; and a second generation module configured to generate the estimated profile based on the second positive electrode profile and the second negative electrode profile.

In one embodiment, the first generation module may be configured to generate the second positive electrode profile and the second negative electrode profile by changing at least one of a position, scale, and shape of the first positive electrode profile and the first negative electrode profile on a predetermined coordinate axis.

In one embodiment, the second generation module may be configured to generate the estimated profile by calculating a potential difference for each SOC between the second positive electrode profile and the second negative electrode profile.

A battery pack according to another aspect of the present disclosure includes the battery diagnosing apparatus described above.

A vehicle according to another aspect of the present disclosure includes the battery diagnosing apparatus described above.

### Advantageous Effects

According to the present disclosure, diagnosis for a target battery is performed based on OCV values of the target battery sampled only within a partial SOC range, rather than the entire SOC range of the target battery. This may shorten the diagnosis time and enable diagnosis for batteries that are charged and discharged at a high current rate.

Further, performing the diagnosis based on the OCV values sampled during the use of the target battery may enable real-time battery-status diagnosis and rapid diagnosis result provision in on-board systems such as battery management systems for battery packs or electric vehicles.

Furthermore, the diagnosis is performed based on an estimated profile generated by shifting or deforming a positive electrode profile and negative electrode profile of a predetermined reference battery and combining them, so that the computation load required for diagnosis may be reduced, while securing the accuracy and reliability of the diagnosis results.

Furthermore, those skilled in the art will readily understand from the following description that various embodiments of the present disclosure may solve various technical issues not mentioned above.

### DESCRIPTION OF DRAWINGS

FIG. 1 is a block diagram illustrating a battery diagnosing apparatus according to one embodiment of the present disclosure.
FIG. 2 is a diagram illustrating OCV values sampled within a partial SOC range of a target battery.
FIG. 3 is a diagram illustrating an OCV curve corresponding to the sampled OCV values of FIG. 2.
FIG. 4 is a diagram illustrating a positive electrode profile and negative electrode profile corresponding to the sampled OCV values of FIG. 2.
FIG. 5 is a diagram illustrating an estimated profile generated based on the positive electrode profile and the negative electrode profile of FIG. 4.
FIG. 6 is a diagram illustrating information obtained based on the estimated profile.
FIG. 7 is a flowchart illustrating a battery diagnosing method according to one embodiment of the present disclosure.
FIG. 8 is a diagram illustrating a battery pack according to one embodiment of the present disclosure.
FIG. 9 is a diagram illustrating a vehicle according to one embodiment of the present disclosure.

### BEST MODE

Hereinafter, embodiments according to the present disclosure will be described in detail with reference to the accompanying drawings to clearly describe solutions corresponding to the technical issues of the present disclosure. However, when describing the present disclosure, descriptions of related known technologies may be omitted if they obscure the gist of the present disclosure.

In addition, the terms used in this specification are defined in consideration of the functions in the present disclosure, and may vary depending on the intention of the designer or manufacturer, customs, and other factors. Therefore, the definitions of the terms described below need to be derived based on the overall content of this specification.

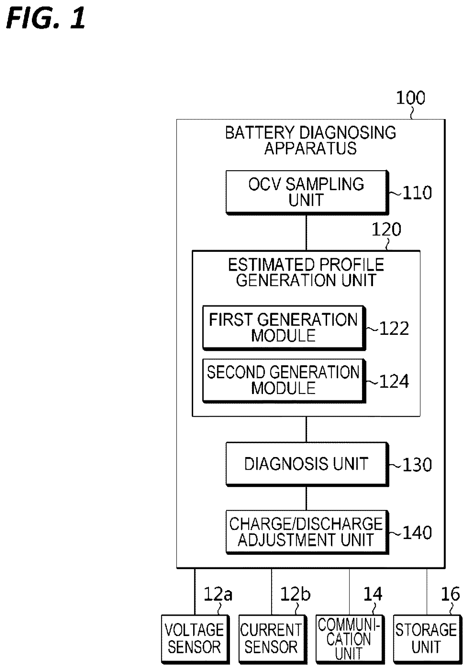

FIG. 1 is a block diagram illustrating a battery diagnosing apparatus 100 according to one embodiment of the present disclosure.

As illustrated in FIG. 1, the battery diagnosing apparatus 100 according to one embodiment of the present disclosure is an apparatus configured to diagnose the status of a rechargeable battery, and includes an OCV sampling unit 110, an estimated profile generation unit 120, and a diagnosis unit 130.

A battery (hereinafter, referred to as "target battery") to be diagnosed by the battery diagnosing apparatus 100 according to the present disclosure may be a battery cell corresponding to a basic charge/discharge unit, a battery module in which multiple battery cells are connected in series and/or in parallel, or a battery pack in which multiple battery cells or multiple battery modules are connected in series and/or in parallel.

The OCV sampling unit 110 is configured to sample the Open Circuit Voltage (OCV) value of a target battery within a partial State of Charge (SOC) range among the entire SOC range of the target battery. For example, when the entire SOC range of the target battery is from 0[%] to 100[%], the OCV sampling unit 110 may be configured to sample the OCV value of the target battery within a partial SOC range between about 10[%] and 80[%]. For reference, the entire SOC range of the target battery may vary depending on the deterioration of the target battery.

As will be described again below, the estimated profile generation unit 120 is configured to generate an estimated profile, which estimates OCV values of the target battery corresponding to the entire SOC range based on the OCV values sampled within the partial SOC range.

Further, the diagnosis unit 130 is configured to diagnose the target battery based on the estimated profile. For example, the diagnosis unit 130 may be configured to use information obtained from the estimated profile to diagnose the status of the target battery, such as the degree of deterioration of the target battery, the positive electrode/negative electrode capacity loss rate, and the available lithium loss rate.

In one embodiment, the OCV sampling unit 110 may be configured to sample the OCV value of the target battery at each idle period of the target battery that occurs discontinuously within the partial SOC range during the charge or discharge of the target battery. In this case, the idle period of the target battery may be configured to occur when a specific condition is met or to occur at predetermined times.

Further, in one embodiment, the OCV sampling unit 110 may be configured to sample the OCV value of the target battery a number of times corresponding to a predetermined reference number of times within the partial SOC range.

When the number of sampling times of the OCV sampling unit 110 is too small, the accuracy of the estimated profile generated by the estimated profile generation unit 120 may decrease. Meanwhile, when the number of sampling times is too large, the overall diagnosis time of the battery diagnosing apparatus 100 may increase due to an increase in computational load. Therefore, the number of sampling times of the OCV sampling unit 110 needs to be appropriately determined so as to shorten the diagnosis time while ensuring the accuracy of the estimated profile.

Meanwhile, the partial SOC range where the OCV value is sampled, among the entire SOC range of the target battery, may be determined by various factors such as the usage status of the target battery, the SOC range or voltage range of the target battery where charging and discharging frequently occur, or the designer's intention.

In one embodiment, the OCV sampling unit 110 may be configured to sample the OCV value of the target battery within a partial voltage range between a predetermined first voltage and second voltage among the entire voltage range of the target battery.

For example, when the entire voltage range of the target battery is from 2.5 [V] to 4.2 [V], the OCV sampling unit 110 may be configured to sample the OCV value of the target battery within a partial voltage range between 3.4 [V] and 4.05 [V].

As mentioned above, the estimated profile generation unit 120 may generate an estimated profile, which estimates OCV values corresponding to the entire SOC range of the target battery based on the sampled OCV values within the partial SOC range. For this, the estimated profile generation unit 120 may include a first generation module 122 and a second generation module 124.

The first generation module 122 may be configured to generate a second positive electrode profile and a second negative electrode profile corresponding to the sampled OCV values based on a first positive electrode profile, which represents a correlation between the SOC and positive electrode potential of a predetermined reference battery, and a first negative electrode profile, which represents a correlation between the SOC and a negative electrode potential of the reference battery. The reference battery may be the target battery at the time of Beginning of Life (BOL), or a normal-status battery with the same configuration as the target battery.

In this case, the first generation module 122 may be configured to generate the second positive electrode profile and the second negative electrode profile corresponding to the sampled OCV values by changing at least one of the position, scale, and shape of the first positive electrode profile and the first negative electrode profile on a predetermined coordinate axis.

That is, as the second positive electrode profile and the second negative electrode profile described above, a candidate positive electrode profile and a candidate negative electrode profile that create a curve with the smallest error relative to a curve connecting the sampled OCV values through mutual combination may be determined, respectively, among various candidate positive electrode profiles and various candidate negative electrode profiles, which are generated by shifting or deforming the first positive electrode profile and the first negative electrode profile on the SOC-OCV coordinate axis.

The second generation module 124 may be configured to generate the estimated profile based on the second positive electrode profile and the second negative electrode profile.

In this case, the second generation module 124 may be configured to generate the estimated profile by calculating the potential difference for each SOC between the second positive electrode profile and the second negative electrode profile.

As a result, the diagnosis unit 130 may diagnose the target battery based on the estimated profile.

For example, the diagnosis unit 130 may obtain an estimated positive electrode profile, which estimates a correlation between the SOC and positive electrode potential of the target battery, and an estimated negative electrode profile, which estimates a correlation between the SOC and negative electrode potential of the target battery, from the estimated profile.

Next, the diagnosis unit 130 may diagnose the target battery using diagnosis information included in at least one of the estimated positive electrode profile and the estimated negative electrode profile. The diagnosis information may include at least one of the initial potential, final potential, and shrinkage of the estimated positive electrode profile, and the initial potential, final potential, and shrinkage of the estimated negative electrode profile.

The shrinkage of the estimated positive electrode profile indicates the degree of shrinkage of the estimated positive electrode profile in a predetermined direction compared to a predetermined reference positive electrode profile.

Similarly, the shrinkage of the estimated negative electrode profile indicates the degree of shrinkage of the estimated negative electrode profile in a predetermined direction compared to a predetermined reference negative electrode profile.

For example, the diagnosis unit 130 may be configured to diagnose the target battery by comparing the diagnosis information with pre-stored reference information. In this case, the reference information may be information included in a reference positive electrode profile, which represents a correlation between the SOC and positive electrode potential of a predetermined reference battery, and a reference negative electrode profile, which represents a correlation between the SOC and negative electrode potential of the reference battery. In other words, the reference information may include at least one of the initial potential, final potential, and shrinkage of the reference positive electrode profile, and the initial potential, final potential, and shrinkage of the reference negative electrode profile.

The reference battery may be the target battery at the time of BOL, or a normal-status battery with the same configuration as the target battery.

In one embodiment, the battery diagnosing apparatus 100 may further include a charge/discharge adjustment unit 140.

The charge/discharge adjustment unit 140 may be configured to adjust the full-charge voltage of the target battery or the current rate of charge current or discharge current of the target battery, based on the diagnosis results of the diagnosis unit 130 described above. For example, when the target battery is diagnosed as deteriorated, the charge/discharge adjustment unit 140 may control a charge/discharge unit (not illustrated) that charges and discharges the target battery to lower the full-charge voltage of the target battery or reduce the current rate of charge/discharge current.

The OCV sampling unit 110, estimated profile generation unit 120, diagnosis unit 130, and charge/discharge adjustment unit 140 of the battery diagnosing apparatus 100 described above may be implemented with a combination of a processor and a program executed by the processor. The battery diagnosing apparatus 100 may be implemented with a single processor or two or more interlinked processors.

In one embodiment, the battery diagnosing apparatus 100 according to the present disclosure may be configured to be linked with various sensors such as a voltage sensor 12a for sensing the voltage of the battery and a current sensor 12b for sensing the charge/discharge current of the battery.

Further, the battery diagnosing apparatus 100 according to the present disclosure may be configured to be linked with a communication unit 14 that enables communication with other remote apparatuses. For example, the communication unit 14 may be configured to receive data transmitted from remote servers or communication terminals via a wired or wireless communication network and transmit the data to the battery diagnosing apparatus 100, or to transmit data generated by the battery diagnosing apparatus 100 to other servers or communication terminals. To this end, the communication unit 14 may include a communication modem that performs wired communication or wireless communication.

Further, the battery diagnosing apparatus 100 according to the present disclosure may be configured to be linked with a storage unit 16 capable of storing programs or data required for battery diagnosis. In this case, the storage unit 16 may include one, or two or more of various types of recording media such as Random Access Memory (RAM), Read Only Memory (ROM), Electrically Erasable Programmable Read Only Memory (EEPROM), flash memory, and registers.

In another embodiment, the battery diagnosing apparatus 100 according to the present disclosure may be configured to include one, or two or more of the voltage sensor 12a, current sensor 12b, communication unit 14, and storage unit 16 described above.

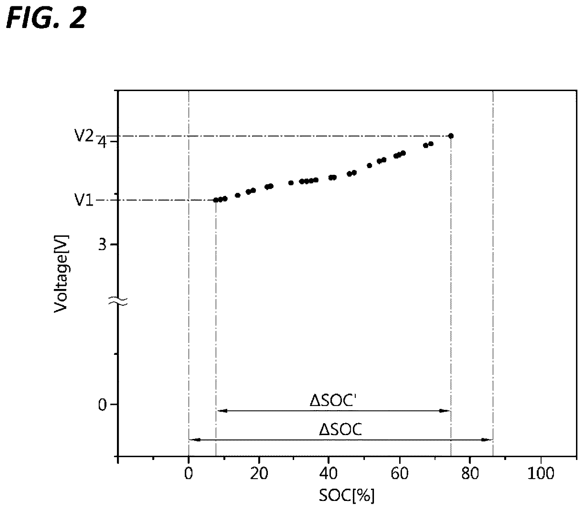

FIG. 2 is a diagram illustrating OCV values sampled within a partial SOC range of a target battery.

As illustrated in FIG. 2, the OCV sampling unit 110 may sample the OCV value of the target battery within a partial SOC range ΔSOC' among the entire SOC range ΔSOC of the target battery.

For example, the OCV sampling unit 110 may sample the OCV value of the target battery at each idle period of the target battery that occurs discontinuously within the partial SOC range ΔSOC' during the charge or discharge of the target battery.

In this case, the partial SOC range where the OCV value is sampled, among the entire SOC range of the target battery, may be determined by various factors such as the usage status of the target battery, the SOC range or voltage range of the target battery where charging and discharging frequently occur, or the designer's intention. Further, the idle period of the target battery may be configured to occur when a specific condition is met or to occur at predetermined times.

In one embodiment, the OCV sampling unit 110 may be configured to sample the OCV value of the target battery within a partial voltage range between a predetermined first voltage V1 and second voltage V2 among the entire voltage range of the target battery.

Further, the OCV sampling unit 110 may sample the OCV value of the target battery a number of times corresponding to a predetermined reference number of times within the partial SOC range ΔSOC'.

The estimated profile generation unit 120 may generate an estimated profile, which estimates the OCV values of the target battery corresponding to the entire SOC range ΔSOC based on the OCV values sampled as described above.

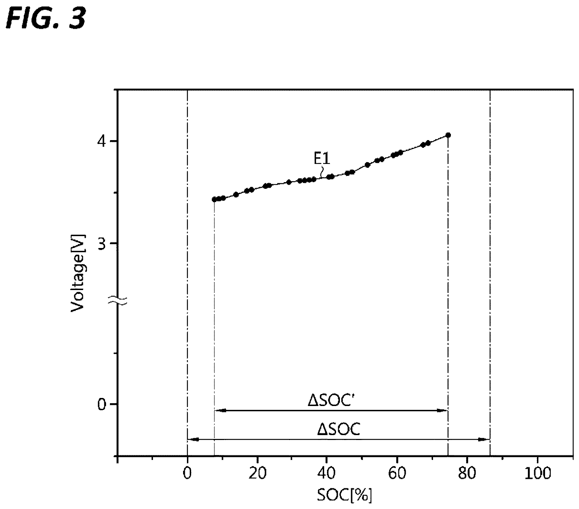

FIG. 3 is a diagram illustrating an OCV curve corresponding to the sampled OCV values of FIG. 2.

As illustrated in FIG. 3, the estimated profile generation unit 120 may obtain an OCV curve E1, which partially represents a correlation between the SOC and OCV of the target battery, by connecting the OCV values sampled within the partial SOC range ΔSOC'.

Next, the estimated profile generation unit 120 may generate a positive electrode profile and negative electrode profile corresponding to the sampled OCV values.

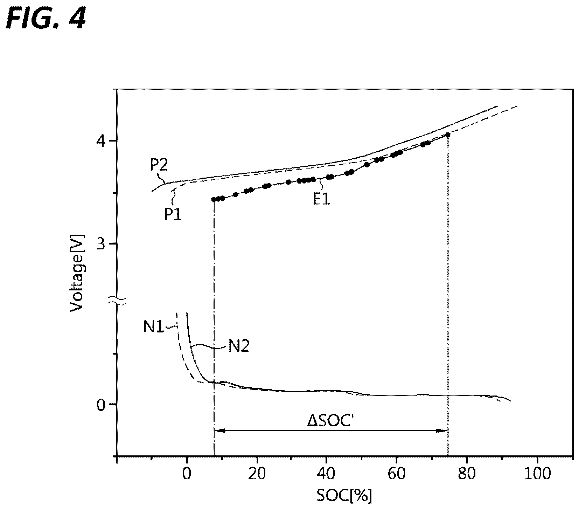

FIG. 4 is a diagram illustrating a positive electrode profile and negative electrode profile corresponding to the sampled OCV values of FIG. 2.

As illustrated in FIG. 4, the first generation module 122 of the estimated profile generation unit 120 may generate a second positive electrode profile P2 and a second negative electrode profile N2 corresponding to the sampled OCV values based on a first positive electrode profile P1, which represents a correlation between the SOC and positive electrode potential of a predetermined reference battery, and a first negative electrode profile N1, which represents a correlation between the SOC and negative electrode potential of the reference battery. The reference battery may be the target battery at the time of BOL, or a normal-status battery with the same configuration as the target battery.

In this case, the first generation module 122 may generate the second positive electrode profile P2 and the second negative electrode profile N2 corresponding to the sampled OCV values by changing at least one of the position, scale, and shape of the first positive electrode profile P1 and the first negative electrode profile N1 on the SOC-OCV coordinate axis.

For example, among various candidate positive electrode profiles and various candidate negative electrode profiles, which are generated by shifting or deforming the first positive electrode profile P1 and the first negative electrode profile N1 on the SOC-OCV coordinate axis, a candidate positive electrode profile and a candidate negative electrode profile that create a curve with the smallest error relative to the OCV curve E1 connecting the sampled OCV values through mutual combination may be determined as the second positive electrode profile P2 and the second negative electrode profile N2.

Next, the second generation module 124 of the estimated profile generation unit 120 may generate an estimated profile that represents a correlation between the SOC and OCV of the target battery in the entire SOC range ΔSOC of the target battery based on the second positive electrode profile P2 and the second negative electrode profile N2.

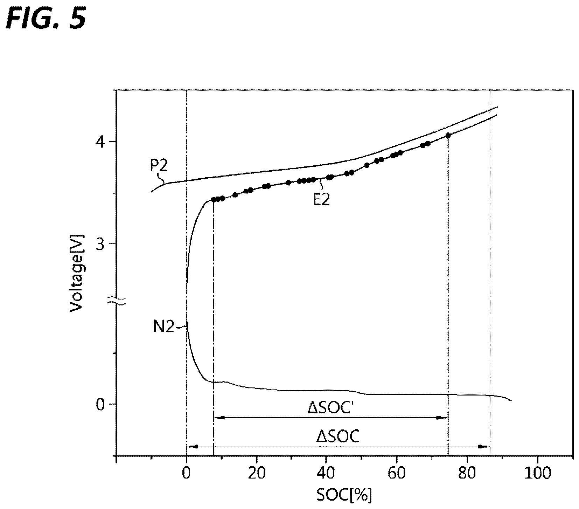

FIG. 5 is a diagram illustrating an estimated profile E2 generated based on the second positive electrode profile P2 and the second negative electrode profile N2 of FIG. 4.

As illustrated in FIG. 5, the second generation module 124 may generate the estimated profile E2 by calculating the potential difference for each SOC between the second positive electrode profile P2 and the second negative electrode profile N2.

Next, the diagnosis unit 130 may diagnose the target battery based on the estimated profile E2.

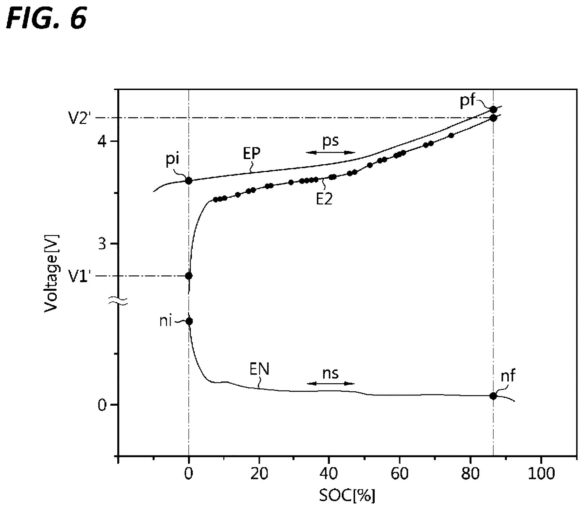

FIG. 6 is a diagram illustrating information obtained based on the estimated profile.

As illustrated in FIG. 6, the diagnosis unit 130 may obtain an estimated positive electrode profile EP, which estimates a correlation between the SOC and positive electrode potential of the target battery, and an estimated negative electrode profile EN, which estimates a correlation between the SOC and negative electrode potential of the target battery, from the estimated profile E2.

In one embodiment, the estimated positive electrode profile EP may be obtained by extracting a section corresponding to the entire SOC range of the target battery from the second positive electrode profile P2 used to generate the estimated profile E2.

Further, the estimated negative electrode profile EN may be obtained by extracting a section corresponding to the entire SOC range of the target battery from the second negative electrode profile N2 used to generate the estimated profile E2.

In this case, the entire SOC range of the target battery may be defined as a range between a minimum SOC value corresponding to a voltage V1' when the target battery is fully discharged and a maximum SOC value corresponding to a voltage V2' when the target battery is fully charged.

In another embodiment, the estimated positive electrode profile EP and the estimated negative electrode profile EN may be obtained through a simulation that identifies a positive electrode profile and a negative electrode profile that generate a profile most similar to the estimated profile E2 by mutual combination.

Next, the diagnosis unit 130 may diagnose the target battery using diagnosis information included in at least one of the estimated positive electrode profile EP and the estimated negative electrode profile EN. The diagnosis information may include at least one of the initial potential pi, final potential pf, and shrinkage ps of the estimated positive electrode profile EP, and the initial potential ni, final potential nf, and shrinkage ns of the estimated negative electrode profile EN.

Here, the shrinkage ps of the estimated positive electrode profile EP indicates the degree of shrinkage of the estimated positive electrode profile EP in the SOC axis direction compared to a predetermined reference positive electrode profile.

Similarly, the shrinkage ns of the estimated negative electrode profile EN indicates the degree of shrinkage of the estimated negative electrode profile EN in the SOC axis direction compared to a predetermined reference negative electrode profile.

Next, the diagnosis unit 130 may diagnose the target battery by comparing the diagnosis information with pre-stored reference information. In this case, the reference information may be information included in a reference positive electrode profile, which represents a correlation between the SOC and positive electrode potential of a predetermined reference battery, and a reference negative electrode profile, which represents a correlation between the SOC and negative electrode potential of the reference battery.

In other words, the reference information may include at least one of the initial potential, final potential, and shrinkage of the reference positive electrode profile, and the initial potential, final potential, and shrinkage of the reference negative electrode profile.

The reference battery may be the target battery at the time of BOL, or a normal-status battery with the same configuration as the target battery.

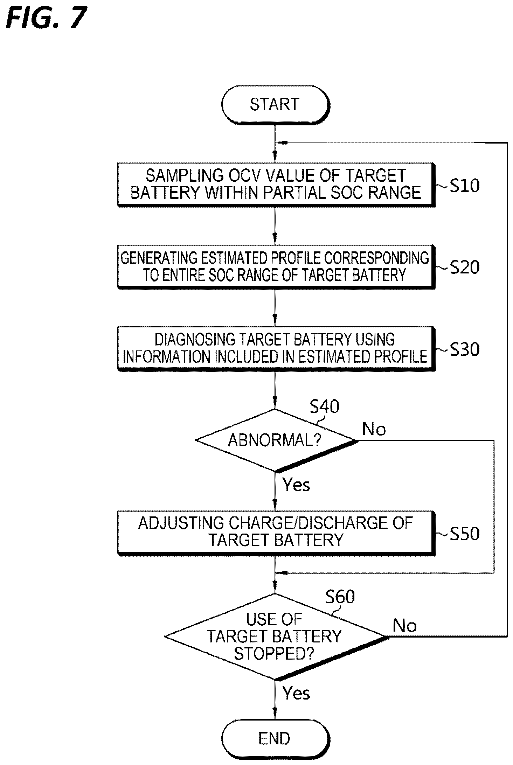

FIG. 7 is a flowchart illustrating a battery diagnosing method according to one embodiment of the present disclosure.

As illustrated in FIG. 7, the battery diagnosing method according to the present disclosure is a method of diagnosing a rechargeable battery, which may be executed by a processor.

Further, a target battery to be diagnosed by the battery diagnosing method according to the present disclosure may be a battery cell corresponding to a basic charge/discharge unit, a battery module in which multiple battery cells are connected in series and/or in parallel, or a battery pack in which multiple battery cells or multiple battery modules are connected in series and/or in parallel.

First, the processor samples the OCV value of the target battery within a partial SOC range among the entire SOC range of the target battery (S10).

For example, the processor may sample the OCV value of the target battery at each idle period of the target battery that occurs discontinuously within the partial SOC range during the charge or discharge of the target battery.

In this case, the partial SOC range where the OCV value is sampled, among the entire SOC range of the target battery, may be determined by various factors, such as the usage status of the target battery, the SOC range or voltage range of the target battery where charging and discharging frequently occur, or the designer's intention. Further, the idle period of the target battery may be configured to occur when a specific condition is met or to occur at predetermined times.

In one embodiment, the processor may be configured to sample the OCV value of the target battery within a partial voltage range between a predetermined first voltage and second voltage among the entire voltage range of the target battery.

Further, the processor may sample the OCV value of the target battery a number of times corresponding to a predetermined reference number of times within a partial SOC range.

Next, the processor may generate an estimated profile, which estimates the OCV values of the target battery corresponding to the entire SOC range based on the OCV values sampled as described above (S20).

As described above with reference to FIG. 3, the processor may obtain the OCV curve E1, which partially represents a correlation between the SOC and OCV of the target battery, by connecting the OCV values sampled within the partial SOC range ΔSOC'.

Next, the processor may generate a positive electrode profile and a negative electrode profile corresponding to the sampled OCV values.

As described above with reference to FIG. 4, the processor may generate the second positive electrode profile P2 and the second negative electrode profile N2 corresponding to the sampled OCV values based on the first positive electrode profile P1, which represents a correlation between the SOC and positive electrode potential of a predetermined reference battery, and the first negative electrode profile N1, which represents a correlation between the SOC and negative electrode potential of the reference battery. The reference battery may be the target battery at the time of BOL, or a normal-status battery with the same configuration as the target battery.

In this case, the processor may generate the second positive electrode profile P2 and the second negative electrode profile N2 corresponding to the sampled OCV values by changing at least one of the position, scale, and shape of the first positive electrode profile P1 and the first negative electrode profile N1 on the SOC-OCV coordinate axis.

For example, the processor may determine, as the second positive electrode profile P2 and the second negative electrode profile N2, a candidate positive electrode profile and a candidate negative electrode profile that create a curve with the smallest error relative to the OCV curve E1 connecting the sampled OCV values through mutual combination, among various candidate positive electrode profiles and various candidate negative electrode profiles, which are generated by shifting or deforming the first positive electrode profile P1 and the first negative electrode profile N1 on the SOC-OCV coordinate axis.

Next, the processor may generate the estimated profile E2 representing a correlation between the SOC and OCV of the target battery in the entire SOC range of the target battery based on the second positive electrode profile P2 and the second negative electrode profile N2.

As described above with reference to FIG. 5, the processor may generate the estimated profile E2 by calculating the potential difference for each SOC between the second positive electrode profile P2 and the second negative electrode profile N2.

Next, the processor may diagnose the target battery based on the estimated profile E2 (S30).

As described above with reference to FIG. 6, the processor may obtain the estimated positive electrode profile EP, which estimates a correlation between the SOC and positive electrode potential of the target battery, and the estimated negative electrode profile EN, which estimates a correlation between the SOC and negative electrode potential of the target battery, from the estimated profile E2.

In one embodiment, the estimated positive electrode profile EP may be obtained by extracting a section corresponding to the entire SOC range of the target battery from the second positive electrode profile P2 used to generate the estimated profile E2.

Further, the estimated negative electrode profile EN may be obtained by extracting a section corresponding to the entire SOC range of the target battery from the second negative electrode profile N2 used to generate the estimated profile E2.

In this case, the entire SOC range of the target battery may be defined as a range between a minimum SOC value corresponding to the voltage V1' when the target battery is fully discharged and a maximum SOC value corresponding to the voltage V2' when the target battery is fully charged.

In another embodiment, the estimated positive electrode profile EP and the estimated negative electrode profile EN may be obtained through a simulation that identifies a positive electrode profile and a negative electrode profile that generate a profile most similar to the estimated profile E2 by mutual combination.

Next, the processor may diagnose the target battery using diagnosis information included in at least one of the estimated positive electrode profile EP and the estimated negative electrode profile EN. The diagnosis information may include at least one of the initial potential pi, final potential pf, and shrinkage ps of the estimated positive electrode profile EP, and the initial potential ni, final potential nf, and shrinkage ns of the estimated negative electrode profile EN.

Here, the shrinkage ps of the estimated positive electrode profile EP indicates the degree of shrinkage of the estimated positive electrode profile EP in the SOC axis direction compared to a predetermined reference positive electrode profile.

Similarly, the shrinkage ns of the estimated negative electrode profile EN indicates the degree of shrinkage of the estimated negative electrode profile EN in the SOC axis direction compared to a predetermined reference negative electrode profile.

Next, the processor may diagnose the target battery by comparing the diagnosis information with pre-stored reference information. In this case, the reference information may be information included in a reference positive electrode profile, which represents a correlation between the SOC and positive electrode potential of a predetermined reference battery, and a reference negative electrode profile, which represents a correlation between the SOC and negative electrode potential of the reference battery.

In other words, the reference information may include at least one of the initial potential, final potential, and shrinkage of the reference positive electrode profile, and the initial potential, final potential, and shrinkage of the reference negative electrode profile.

The reference battery may be the target battery at the time of BOL, or a normal-status battery with the same configuration as the target battery.

Next, the processor may adjust the full-charge voltage of the target battery or the current rate of charge current or discharge current of the target battery, based on the diagnosis results for the target battery (S40 and S50). For example, when the target battery is diagnosed as deteriorated, the processor may control a charge/discharge unit (not illustrated) that charges and discharges the target battery to lower the full-charge voltage of the target battery or reduce the current rate of charge/discharge current.

The processor may repeat the above-described processes S10 to S50 until the use of the target battery is stopped (S60).

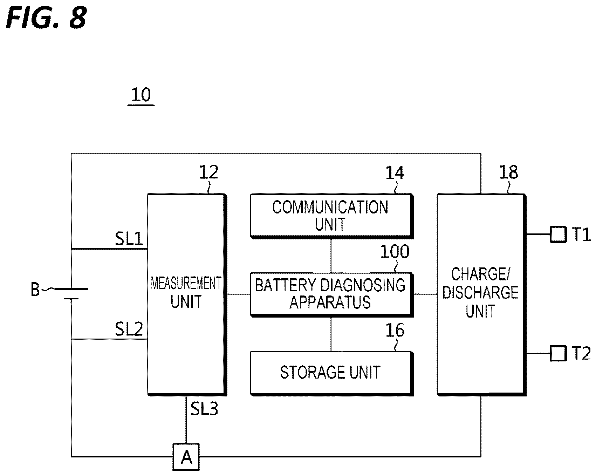

FIG. 8 is a diagram illustrating a battery pack 10 according to one embodiment of the present disclosure.

As illustrated in FIG. 8, the battery pack 10 includes a rechargeable battery B and the battery diagnosing apparatus 100 according to the present disclosure. In one embodiment, the battery pack 10 may optionally further include a measurement unit 12, the communication unit 14, the storage unit 16, and a charge/discharge unit 18.

The measurement unit 12 may be configured to measure the voltage and/or current of the battery B. To this end, the measurement unit 12 may include the voltage sensor 12a and the current sensor 12b described above with reference to FIG. 1.

The measurement unit 12 may measure the voltage of the battery B through a first sensing line SL1 and a second sensing line SL2. Further, the measurement unit 12 may measure the current of the battery B through a third sensing line SL3 connected to a current measurement circuit A. The current measurement circuit A may include a shunt resistor.

The battery diagnosing apparatus 100 according to one embodiment of the present disclosure may sample the OCV values of the battery B via the measurement unit 12.

The communication unit 14 may be configured to enable communication with other remote apparatuses. For example, the communication unit 14 may be configured to receive data transmitted from remote servers or communication terminals via a wired or wireless communication network and transmit the data to the battery diagnosing apparatus 100, or to transmit data generated by the battery diagnosing apparatus 100 to other servers or communication terminals. To this end, the communication unit 14 may include a communication modem that performs wired communication or wireless communication.

The storage unit 16 may be configured to store programs or data required for battery diagnosis. In this case, the storage unit 16 may include one, or two or more of various types of recording media such as RAM, ROM, EEPROM, flash memory, and registers.

The charge/discharge unit 18 may be configured to charge and/or discharge the battery B. To this end, the charge/discharge unit 18 may include a charger for charging the battery B, a discharger for discharging the battery B, and at least one switch for electrically connecting the battery B to terminals T1 and T2 of the battery pack 10.

The battery diagnosing apparatus 100 according to one embodiment of the present disclosure may control the charge/discharge unit 18 to proceed with or stop the charge or discharge of the battery B, to set charge/discharge conditions, or to change the set charge/discharge conditions.

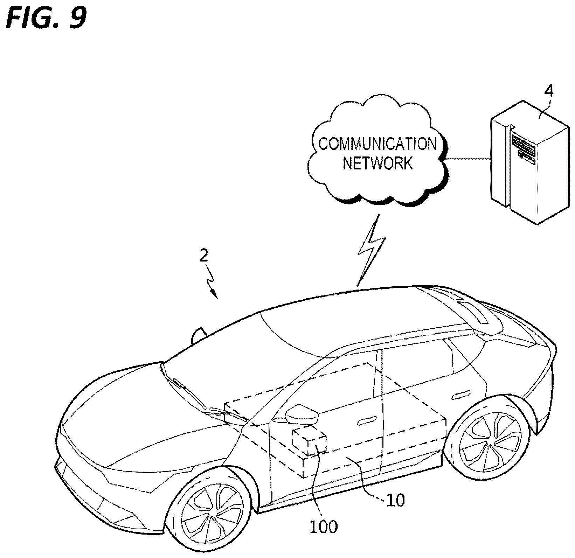

FIG. 9 is a diagram illustrating a vehicle according to one embodiment of the present disclosure.

As illustrated in FIG. 9, the vehicle 2 according to one embodiment of the present disclosure may include the battery pack 10, which provides electric energy required for the operation of the vehicle, and the battery diagnosing apparatus 100 according to the present disclosure.

In this case, the battery diagnosing apparatus 100 may be configured to be linked with an Electronic Control Unit (ECU), which controls the operation of the vehicle 2, or a Battery Management System (BMS) of the battery pack 10.

Further, the battery diagnosing apparatus 100 may be configured to receive data transmitted from a remote server 4 via a wired or wireless communication network, or to transmit data generated by the battery diagnosing apparatus 100 to the server 4.

For reference, the battery diagnosing apparatus 100 according to the present disclosure may be applied to various electric devices or electric systems other than vehicles, and may also be applied to an Energy Storage System (ESS).

As described above, according to the present disclosure, diagnosis of a target battery is performed based on OCV values of the target battery sampled only within a partial SOC range, rather than the entire SOC range of the target battery. This may shorten the diagnosis time and enable diagnosis for batteries that are charged and discharged at a high current rate.

Further, performing the diagnosis based on the OCV values sampled during the use of the target battery may enable real-time battery-status diagnosis and rapid diagnosis result provision in on-board systems such as battery management systems for battery packs or electric vehicles.

Furthermore, the diagnosis is performed based on an estimated profile generated by shifting or deforming a positive electrode profile and negative electrode profile of a predetermined reference battery and combining them, so that the computation load required for diagnosis may be reduced, while ensuring the accuracy and reliability of the diagnosis results.

Furthermore, it goes without saying that the embodiments of the present disclosure may solve various other technical issues not only in the present technical field but also in related technical fields, other than those mentioned in this specification.

The present disclosure has been described so far with reference to the specific embodiments. However, those skilled in the art will clearly understand that various modifications may be implemented within the technical scope of the present disclosure. Therefore, the embodiments disclosed above should be considered not as restrictive but as illustrative. That is, the true technical scope of the present disclosure is defined by the claims, and all differences within the scope equivalent thereto should be interpreted as being included in the present disclosure.

### [Reference Signs]

2: vehicle
10: battery pack
100: battery diagnosing apparatus
110: OCV sampling unit
120: estimated profile generating unit
130: diagnosis unit
140: charge/discharge adjustment unit

## Claims

1. A battery diagnosing method performed by a processor, the method comprising:
a sampling step of sampling an OCV value of a target battery within a partial SOC range among an entire SOC range of the target battery;
a generation step of generating an estimated profile, which estimates OCV values of the target battery corresponding to the entire SOC range based on the OCV values sampled within the partial SOC range; and
a diagnosis step of diagnosing the target battery based on the estimated profile.

2. The battery diagnosing method according to claim 1, wherein the sampling step includes sampling the OCV value of the target battery at each idle period of the target battery that occurs discontinuously within the partial SOC range during charge or discharge of the target battery.

3. The battery diagnosing method according to claim 1, wherein the sampling step includes sampling the OCV value of the target battery a number of times corresponding to a predetermined reference number of times within the partial SOC range.

4. The battery diagnosing method according to claim 1, wherein the generation step includes:
a first generation step of generating a second positive electrode profile and second negative electrode profile corresponding to the sampled OCV values based on a first positive electrode profile representing a correlation between an SOC and a positive electrode potential of a predetermined reference battery and a first negative electrode profile representing a correlation between the SOC and a negative electrode potential of the reference battery, prior to generating the estimated profile; and
a second generation step of generating the estimated profile based on the second positive electrode profile and the second negative electrode profile.

5. The battery diagnosing method according to claim 4, wherein the first generation step includes generating the second positive electrode profile and the second negative electrode profile by changing at least one of a position, scale, and shape of the first positive electrode profile and the first negative electrode profile on a predetermined coordinate axis.

6. The battery diagnosing method according to claim 4, wherein the second generation step includes generating the estimated profile by calculating a potential difference for each SOC between the second positive electrode profile and the second negative electrode profile.

7. The battery diagnosing method according to claim 1, wherein the diagnosis step includes:
obtaining an estimated positive electrode profile that estimates a correlation between an SOC and a positive electrode potential of the target battery and an estimated negative electrode profile that estimates a correlation between the SOC and a negative electrode potential of the target battery from the estimated profile; and
diagnosing the target battery using information included in at least one of the estimated positive electrode profile and the estimated negative electrode profile.

8. The battery diagnosing method according to claim 7, wherein
the information includes at least one of an initial potential, final potential, and shrinkage of the estimated positive electrode profile, and an initial potential, final potential, and shrinkage of the estimated negative electrode profile,
the shrinkage of the estimated positive electrode profile indicates a degree of shrinkage of the estimated positive electrode profile in a predetermined direction compared to a predetermined reference positive electrode profile, and
the shrinkage of the estimated negative electrode profile indicates a degree of shrinkage of the estimated negative electrode profile in a predetermined direction compared to a predetermined reference negative electrode profile.

9. The battery diagnosing method according to claim 1, further comprising:
a step of adjusting a full-charge voltage of the target battery or a current rate of charge current or discharge current of the target battery based on a diagnosis result from the diagnosis step.

10. A battery diagnosing apparatus comprising:
an OCV sampling unit configured to sample an OCV value of a target battery within a partial SOC range among an entire SOC range of the target battery;
an estimated profile generation unit configured to generate an estimated profile, which estimates OCV values of the target battery corresponding to the entire SOC range based on the OCV values sampled within the partial SOC range; and
a diagnosis unit configured to diagnose the target battery based on the estimated profile.

11. The battery diagnosing apparatus according to claim 10, wherein the estimated profile generation unit includes:
a first generation module configured to generate a second positive electrode profile and second negative electrode profile corresponding to the sampled OCV values based on a first positive electrode profile representing a correlation between an SOC and a positive electrode potential of a predetermined reference battery and a first negative electrode profile representing a correlation between the SOC and a negative electrode potential of the reference battery; and
a second generation module configured to generate the estimated profile based on the second positive electrode profile and the second negative electrode profile.

12. The battery diagnosing apparatus according to claim 11, wherein the first generation module is configured to generate the second positive electrode profile and the second negative electrode profile by changing at least one of a position, scale, and shape of the first positive electrode profile and the first negative electrode profile on a predetermined coordinate axis.

13. The battery diagnosing apparatus according to claim 11, wherein the second generation module is configured to generate the estimated profile by calculating a potential difference for each SOC between the second positive electrode profile and the second negative electrode profile.

14. A battery pack comprising the battery diagnosing apparatus according to any one of claims 10 to 13.

15. A vehicle comprising the battery diagnosing apparatus according to any one of claims 10 to 13.
